# EUROPÄISCHE PATENTSCHRIFT

(11) **EP 3 529 660 B1**
(45) Veröffentlichungstag und Bekanntmachung des Hinweises auf die Patenterteilung: **26.07.2023**
(21) Anmeldenummer: 17797242.9
(22) Anmeldetag: 17.10.2017
(51) Int. Cl.: G02F 1/11

(54) **HOCHFREQUENZTREIBERSCHALTUNG FÜR EINE AKUSTOOPTISCHE KOMPONENTE UND VERFAHREN ZUM BETRIEB EINER HF-TREIBERSCHALTUNG**
HIGH-FREQUENCY DRIVER CIRCUIT FOR AN ACOUSTO-OPTICAL COMPONENT AND METHOD FOR OPERATING A HIGH-FREQUENCY DRIVER CIRCUIT
CIRCUIT D'EXCITATION HAUTE FRÉQUENCE POUR UN COMPOSANT ACOUSTO-OPTIQUE ET PROCÉDÉ DE FONCTIONNEMENT D'UN CIRCUIT D'EXCITATION HAUTE FRÉQUENCE

(30) Priorität: 18.10.2016 DE 102016220349
(43) Veröffentlichungstag der Anmeldung: 28.08.2019
(73) Patentinhaber: TRUMPF Schweiz AG, 7214 Grüsch (CH)
(72) Erfinder: BRENNDÖRFER, Knut, 89143 Blaubeuren (DE)
(74) Vertreter: Trumpf Patentabteilung
(86) Internationale Anmeldenummer: PCT/EP2017/076484
(87) Internationale Veröffentlichungsnummer: WO 2018/073254

(56) Entgegenhaltungen:
- DE-A1-102015 218 903
- US-A- 4 444 470
- US-A1- 2009 116 088
- US-B1- 7 994 862
- Bob Dobkin ET AL: "Analog Circuit Design", Analog Devices MT-037 Tutorial, 30. August 2011 (2011-08-30), XP055443667, ISBN: 978-0-12-385185-7 Gefunden im Internet: URL:http://www.analog.com/media/en/trainin g-seminars/tutorials/MT-037.pdf [gefunden am 2018-01-23]

## Beschreibung

Die Erfindung betrifft eine Hochfrequenztreiberschaltung für eine akustooptische Komponente mit einem HF-Leistungsverstärker sowie ein Verfahren zum Betrieb einer HF-Treiberschaltung zur Ansteuerung einer akustooptischen Komponente.

Akustooptische Komponenten, wie beispielsweise akustooptische Modulatoren, werden verwendet, um die Leistung, Frequenz oder Raumrichtung eines Laserstrahls mit einem elektrischen Treibersignal zu steuern. Dies basiert auf dem akustooptischen Effekt, d.h. der Modifikation des Brechungsindex durch den oszillierenden mechanischen Druck einer Schallwelle.

Die US 2009 116 088 A1 offenbart eine optische Einheit umfassend einen akusto-optischen Deflektor und eine Antriebssteuereinheit. Die Antriebssteuereinheit steuert den akustooptischen Deflektor durch Ändern einer Frequenz einer Spannung, die an ein akustooptisches Medium des akustooptischen Deflektors angelegt wird, auf eine Frequenz in einem ersten Frequenzbereich während einer ersten Periode, die eine Ablenkungssteuerperiode darstellt, und Ändern der Frequenz der Spannung auf eine Frequenz in einem zweiten Frequenzbereich, der sich von dem ersten Frequenzbereich unterscheidet, während einer zweiten Periode, die eine Transmissionssteuerperiode darstellt.

US 4 444 470 A offenbart einen akusto-optischen Deflektor, der mit einem Laserlichtstrahl versorgt und parallel mit mehreren Hochfrequenzsignalen angesteuert wird, um mehrere gebeugte abgelenkte Laserlichtstrahlen zu erzeugen. Die Hochfrequenzsignale haben unabhängig gesteuerte Phasen, um zu verhindern, dass die resultierende Kombination der Hochfrequenzsignale eine übermäßig hohe Spitze-zu-Spitze-Amplitude aufweist.

Aus der DE 10 0215 218 903 A1 ist ein Leistungsverstärkungssystem mit einstellbarer Basisschaltungsvorspannung bekannt. Ein Leistungsverstärkungssystem kann einen ersten Transistor mit einer mit einem Hochfrequenzeingang gekoppelten Basis aufweisen. Das Leistungsverstärkungssystem kann weiterhin einen zweiten Transistor umfassen, welcher einen mit einem Kollektor des ersten Transistors gekoppelten Emitter und einem mit einem Hochfrequenzausgang gekoppelten Kollektor aufweist. Das Leistungsverstärkungssystem kann eine Vorspannungskomponente umfassen, welche dazu ausgelegt ist, ein konstantes Vorspannungssignal an die Basis des ersten Transistors und ein einstellbares Vorspannungssignal an die Basis des zweiten Transistors anzulegen.

Der Hochfrequenzwirkungsgrad ist bei vielen verfügbaren Treibern für akustooptische Komponenten relativ schlecht. Auch bei geringen Ausgangsleistungen geht die Leistungsaufnahme kaum zurück, was zu hohen Anforderungen an die Kühlung führt. Die Ein- und Ausschaltzeiten von Hochfrequenztreibern für akustooptische Komponenten sind teilweise relativ lang, insbesondere im Mikrosekundenbereich, während Schaltzeiten im ns-Bereich gewünscht wären, weil das Ein- und Ausschalten oft über einen variablen Verstärker geschieht.

Aufgabe der vorliegenden Erfindung ist es, eine Treiberschaltung für eine akustooptische Komponente bereit zu stellen, der ein schnelles Ein- und Ausschalten bei einem hohen Wirkungsgrad ermöglicht.

Gelöst wird diese Aufgabe durch eine Hochfrequenztreiberschaltung für eine akustooptische Komponente mit den Merkmalen des Patentanspruchs 1. Dadurch ist es möglich, dass der HF-Leistungsverstärker das Signal an seinem Eingang in ein Ausgangssignal verstärkt. Aufgrund der Begrenzung der Versorgungsspannung durch den Spannungsregler kann der HF-Leistungsverstärker außerdem in der Sättigung betrieben werden. Dies bedeutet, dass Veränderungen der Signalform und/oder Amplitude am Eingang des HF-Leistungsverstärkers zu einer in weiten Bereichen proportionalen Veränderung des Signals am Ausgang des Verstärkers führt. Durch den Spannungsregler kann eine einstellbare Gleichspannung erzeugt werden, mit ausreichender Stromreserve zur Versorgung des HF-Leistungsverstärkers.

Übliche HF-Leistungstransistoren benötigen zum einigermaßen linearen Betrieb eine Basisvorspannung (Bipolar-Transistoren) oder eine Gate-Vorspannung (Feldeffekt-Transistoren). Über diese Vorspannung kann der HF-Leistungsverstärker, der einen oder mehrere HF-Leistungstransistoren aufweist, auf einen geringen Ruhestrom eingestellt werden. Durch Abschalten der Vorspannung kann der HF-Leistungsverstärker sehr schnell und effektiv gesperrt werden. Dadurch können sehr schnelle Ein- und Ausschaltzeiten realisiert werden.

Besondere Vorteile ergeben sich, wenn der Spannungsregler als Schaltregler ausgebildet ist. Ein solcher Schaltregler liefert eine variable Ausgangsspannung an den HF-Leistungsverstärker, welcher damit wiederum eine variable Ausgangsleistung mit über einen großen Bereich sehr hohem Wirkungsgrad erzeugt, da der HF-Leistungsverstärker prinzipbedingt immer voll ausgesteuert ist. Somit kann eine geringe Drift der Ausgangsleistung über Temperatur und Zeit erreicht werden, da die Ausgangsleistung durch die zur Verfügung stehende Versorgungsspannung des Schaltreglers definiert wird.

Weitere Vorteile ergeben sich, wenn der Schaltregler als Abwärts-Regler ausgebildet ist. Mit einem solchen Schaltregler ist es möglich, die Versorgungsspannung bis auf 1V bis 2V herunterzufahren. Die maximale Ausgangsspannung kann dabei die Standardarbeitsspannung der HF-Leistungsstransistoren des HF-Leistungsverstärkers, üblicherweise 12V oder 24V, sein.

Der Vorspannungserzeuger kann eingerichtet sein, eine stabilisierte Gleichspannung zu erzeugen. Somit kann beispielsweise eine stabilisierte Gleichspannung von etwa 0,7V bei der Ansteuerung eines Bipolar-Transistors oder etwa 1V bis 3V bei der Ansteuerung eines Feldeffekt-Transistors realisiert werden.

Eine Messeinrichtung zur Messung der Temperatur des HF-Leistungsverstärkers, und insbesondere eine Kompensationseinrichtung zur Ansteuerung des Vorspannungserzeugers in Abhängigkeit der gemessenen Temperatur, können ebenfalls vorgesehen sein. Auf diese Art und Weise ist es besonders einfach möglich, eine stabilisierte Vorspannung zu erzeugen.

Das schaltende Element, über das die Vorspannung an den HF-Leistungsverstärker angeschlossen ist, ist vorzugsweise ein schneller Schalter. Mit diesem kann die Vorspannung an den Eingang des HF-Leistungsverstärkers geschaltet werden. Alternativ kann mit abgeschalteter Spannung der Eingang niederohmig auf Masse gezogen werden. So können der HF-Leistungsverstärker bzw. darin enthaltene Leistungstransistoren möglichst schnell gesperrt werden.

An den Eingang des HF-Leistungsverstärkers kann ein Oszillator angeschlossen sein. Über den Oszillator kann ein HF-Signal erzeugt werden, welches durch den HF-Leistungsverstärker verstärkt wird.

In den Rahmen der Erfindung fällt außerdem ein Verfahren zum Betrieb einer erfindungsgemäßen HF-Treiberschaltung zur Ansteuerung einer akustooptischen Komponente, bei dem ein HF-Leistungsverstärker der HF-Treiberschaltung mit einer einstellbaren Versorgungsspannung versorgt wird, wobei die Ausgangsleistung des HF-Leistungsverstärkers über die einstellbare Versorgungsspannung eingestellt wird und durch Abschalten eines Vorspannungserzeugers bestimmt wird, ob am Ausgang des HF-Leistungs-verstärkers ein verstärktes HF-Signal ausgegeben wird. Insbesondere wird auch durch Zuschalten eines Vorspannungserzeugers bestimmt, ob am Ausgang des HF-Leistungsverstärkers ein verstärktes HF-Signal ausgegeben wird. Insbesondere wird die einstellbare Versorgungsspannung nicht geregelt, sondern gesteuert. Mit diesem Verfahren kann ein sehr schnelles Ein- und Ausschalten bei hohem Wirkungsgrad realisiert werden.

Der Vorspannungserzeuger kann im 10 bis 50 ns-Bereich zugeschaltet werden. Der Vorspannungserzeuger wird im 10 bis 50 ns-Bereich abgeschaltet. Dadurch sind sehr viel schnellere Ein- und Ausschaltzeiten einer akustooptischen Komponente möglich als im Stand der Technik. Das Zu- und Abschalten kann über ein schnell schaltendes Element erfolgen.

Durch den Vorspannungserzeuger kann eine Vorspannung für einen Transistor des HF-Leistungsverstärkers erzeugt werden. Diese Vorspannung fällt geringer aus, wenn der Transistor des HF-Leistungsverstärkers ein Bipolar-Transistor ist. Das kann dann der Bereich von 0,5 bis 0,9 V sein. Handelt es sich dagegen um einen Feldeffekt-Transistor, kann durch den Vorspannungserzeuger eine höhere Spannung erzeugt werden. Die kann dann im Bereich von 1V bis 3V liegen.

Die Vorspannung kann temperaturabhängig erzeugt werden. Insbesondere kann dadurch eine stabilisierte Vorspannung erzeugt werden, was zu einem höheren Wirkungsgrad führt.

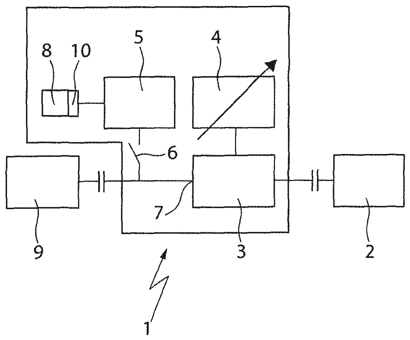

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung ist ein Ausführungsbeispiel der Erfindung dargestellt und in der nachfolgenden Beschreibung näher erläutert.

Die einzige Figur zeigt stark schematisiert eine Hochfrequenz-Treiberschaltung 1 für eine akustooptische Komponente 2, die in diesem Fall als akustooptischer Modulator ausgebildet ist. Die Hochfrequenz-Treiberschaltung 1 weist einen Hochfrequenzleistungsverstärker 3 auf, der zur Versorgung mit einer Versorgungsspannung an einen Spannungsregler 4 angeschlossen ist. Der Spannungsregler 4 ist dabei vorzugsweise als Schaltregler und besonders bevorzugt als Abwärts-Regler ausgebildet.

Weiterhin weist die Hochfrequenz-Treiberschaltung 1 einen Vorspannungserzeuger 5 auf, der über ein schaltendes Element 6 an einen Eingang 7 des HF-Leistungsverstärkers 3 angeschlossen ist. Der HF-Leistungsverstärker 3 verstärkt das von einem Oszillator 9 kommende Signal in ein Ausgangssignal. Der HF-Leistungsverstärker wird aufgrund der Begrenzung der Versorgungsspannung durch den Spannungsregler 4 in der Sättigung betrieben. Der HF-Leistungsverstärker kann als Klasse A-, Klasse B-, Klasse C-Verstärker oder als eine Mischform davon ausgebildet sein.

Durch eine Messeinrichtung 8 wird die Temperatur des HF-Leistungsverstärkers 3 gemessen. In Abhängigkeit der gemessenen Temperatur kann über eine Kompensationseinrichtung 10 durch den Vorspannungserzeuger 5 eine Vorspannung eingestellt werden. Bei geschlossenem schaltendem Element 6 wird die Vorspannung des Vorspannungserzeugers 5 an den HF-Leistungsverstärker 3 gegeben. Der HF-Leistungsverstärker 3 weist HF-Leistungstransistoren auf, die zum linearen Betrieb eine Basisvorspannung, wenn es sich um Bipolar-Transistoren handelt, oder eine Gate-Vorspannung, wenn es sich um Feldeffekt-Transistoren handelt, benötigen. Über die Vorspannung können die Verstärkerstufen des HF-Leistungsverstärkers auf einen geringen Ruhestrom eingestellt werden. Wird das schaltende Element 6 geöffnet, wird die Vorspannung abgeschaltet, was zu einer sehr schnellen und effektiven Sperrung der HF-Leistungstransistoren des HF-Leistungsverstärkers 3 führt. Dies wiederum führt dazu, dass das Signal am Ausgang des HF-Leistungs-verstärkers 3 sehr schnell abgeschaltet wird. Durch Ein- und Ausschalten des schaltenden Elements 6 wird somit bestimmt, ob das vom Oszillator 9 kommende Signal durch den HF-Leistungsverstärker 3 verstärkt wird und ein verstärktes oszillierendes Signal durch den HF-Leistungsverstärker 3 ausgegeben und an die akustooptische Komponente 2 gegeben wird, oder nicht.

Der Spannungsregler 4 liefert eine variable Ausgangsspannung an den HF-Leistungsverstärker 3, welcher damit wiederum eine variable Ausgangsleistung mit über einen großen Bereich sehr hohem Wirkungsgrad erzeugt.

Der Wirkungsgrad bleibt somit immer optimal. Das schnelle Ein- und Ausschalten des Hochfrequenz-Signals am Ausgang des HF-Leistungsverstärkers 3 erfolgt über das Zu- und Abschalten der durch den Vorspannungserzeuger 5 erzeugten Vorspannung. Dies ist insbesondere im Bereich von 10 bis 50 ns möglich.

## Patentansprüche

1. Hochfrequenz (HF) -Treiberschaltung (1) für eine akustooptische Komponente (2), **dadurch gekennzeichnet, dass** die HF-Treiberschaltung (1) einen HF-Leistungsverstärker (3), der zur Versorgung mit einer Versorgungsspannung an einen Spannungsregler (4) angeschlossen ist und einen Vorspannungserzeuger (5), der über ein schaltendes Element (6) an einen Eingang (7) des Leistungsverstärkers (3) angeschlossen ist, aufweist, wobei das schaltende Element (6) eingerichtet ist, den Vorspannungserzeuger (5) im 10 bis 50 ns-Bereich abzuschalten.

2. Treiberschaltung nach Anspruch 1, **dadurch gekennzeichnet, dass** der Spannungsregler (4) als Schaltregler ausgebildet ist.

3. Treiberschaltung nach einem der vorhergehenden Ansprüche, **dadurch gekennzeichnet, dass** der Vorspannungserzeuger (5) eingerichtet ist, eine stabilisierte Spannung zu erzeugen.

4. Treiberschaltung nach einem der vorhergehenden Ansprüche, **dadurch gekennzeichnet, dass** eine Messeinrichtung (8) zur Messung der Temperatur des HF-Leistungsverstärkers (3) vorgesehen ist.

5. Treiberschaltung nach Anspruch 4, **dadurch gekennzeichnet, dass** eine Kompensationseinrichtung (10) zur Ansteuerung des Vorspannungserzeugers in Abhängigkeit der gemessenen Temperatur vorgesehen sind.

6. Treiberschaltung nach einem der vorhergehenden Ansprüche, **dadurch gekennzeichnet, dass** ein Oszillator (9) an den Eingang (7) des HF-Leistungsverstärkers (3) angeschlossen ist.

7. Verfahren zum Betrieb einer HF-Treiberschaltung (1) nach einem der Ansprüche 1 bis 6 zur Ansteuerung einer akustooptischen Komponente (2), bei dem ein HF-Leistungsverstärker (3) der HF-Treiberschaltung (1) mit einer einstellbaren Versorgungsspannung versorgt wird, wobei die Ausgangsleistung des HF-Leistungsverstärkers (3) über die einstellbare Versorgungsspannung eingestellt wird und durch Abschalten, und insbesondere auch durch Zuschalten, eines Vorspannungserzeugers (5) bestimmt wird, ob am Ausgang des HF-Leistungsverstärkers (3) ein verstärktes HF-Signal ausgegeben wird, **dadurch gekennzeichnet, dass** der Vorspannungserzeuger im 10 bis 50 ns-Bereich abgeschaltet, und insbesondere auch zugeschaltet, wird.

8. Verfahren nach Anspruch 7, **dadurch gekennzeichnet, dass** durch den Vorspannungserzeuger (5) eine Vorspannung für einen Transistor des HF-Leistungsverstärkers (3) erzeugt wird.

9. Verfahren nach Anspruch 8, **dadurch gekennzeichnet, dass** die Vorspannung temperaturabhängig erzeugt wird.

## Claims

1. A radio frequency (RF) driver circuit (1) for an acousto-optical component (2), **characterized in that** the RF driver circuit (1) has an RF power amplifier (3) connected to a voltage regulator (4) for supply with a supply voltage and a bias voltage generator (5), which is connected via a switching element (6) to an input (7) of the power amplifier (3), wherein the switching element (6) is designed to switch off the bias voltage generator (5) in the 10 to 50 ns range.

2. The driver circuit according to Claim 1, **characterized in that** the voltage regulator (4) is designed as a switching regulator.

3. The driver circuit according to any one of the preceding claims, **characterized in that** the bias voltage generator (5) is designed to generate a stabilized voltage.

4. The driver circuit according to any one of the preceding claims, **characterized in that** a measurement device (8) for measuring the temperature of the RF power amplifier (3) is provided.

5. The driver circuit according to Claim 4, **characterized in that** a compensation device (10) is provided for controlling the bias voltage generator as a function of the measured temperature.

6. The driver circuit according to any one of the preceding claims, **characterized in that** an oscillator (9) is connected to the input (7) of the RF power amplifier (3).

7. A method for operating an RF driver circuit (1) according to any one of claims 1 to 6 for controlling an acousto-optical component (2), in which an RF power amplifier (3) of the RF driver circuit (1) is supplied with an adjustable supply voltage, wherein the output power of the RF power amplifier (3) is set via the adjustable supply voltage and it is determined by switching off, and in particular also by switching on, a bias voltage generator (5), whether an amplified RF signal is output at the output of the RF power amplifier (3), **characterized in that** the bias voltage generator is switched off, and in particular also switched on, in the 10 to 50 ns range.

8. The method according to Claim 7, **characterized in that** a bias voltage for a transistor of the RF power amplifier (3) is generated by the bias voltage generator (5).

9. The method according to Claim 8, **characterized in that** the bias voltage is generated as a function of the temperature.

## Revendications

1. Circuit d'excitation (1) haute fréquence (HF) pour un composant acousto-optique (2), **caractérisé en ce que** le circuit d'excitation (1) HF comporte un amplificateur de puissance (3) HF, qui, pour être alimenté en tension d'alimentation, est connecté à un régulateur de tension (4) et comporte un générateur de précontrainte (5), qui est connecté, par l'intermédiaire d'un élément (6) à commutation, à une entrée (7) de l'amplificateur de puissance (3), dans lequel l'élément (6) à commutation est conçu pour désactiver le générateur de précontrainte (5) dans la plage comprise entre 10 et 50 ns.

2. Circuit d'excitation selon la revendication 1, **caractérisé en ce que** le régulateur de tension (4) est conçu sous la forme de régulateur de commutation.

3. Circuit d'excitation selon l'une quelconque des revendications précédentes, **caractérisé en ce que** le générateur de précontrainte (5) est conçu pour générer une tension stabilisée.

4. Circuit d'excitation selon l'une quelconque des revendications précédentes, **caractérisé en ce qu'**un dispositif de mesure (8) est conçu pour mesurer la température de l'amplificateur de puissance (3) HF.

5. Circuit d'excitation selon la revendication 4, **caractérisé en ce qu'**un dispositif de compensation (10) est conçu pour commander le générateur de précontrainte en fonction de la température mesurée.

6. Circuit d'excitation selon l'une quelconque des revendications précédentes, **caractérisé en ce qu'**un oscillateur (9) est connecté à l'entrée (7) de l'amplificateur de puissance (3) HF.

7. Procédé de fonctionnement d'un circuit d'excitation (1) HF selon l'une quelconque des revendications 1 à 6 pour commander un composant acousto-optique (2), selon lequel un amplificateur de puissance (3) HF du circuit d'excitation (1) HF est alimenté par une tension d'alimentation réglable, dans lequel la puissance de sortie de l'amplificateur de puissance (3) HF est réglée en fonction de la tension d'alimentation réglable et par mise hors circuit et, en particulier, également par mise en circuit d'un générateur de précontrainte (5), il est déterminé si un signal HF amplifié est délivré à la sortie de l'amplificateur de puissance (3) HF, **caractérisé en ce que** le générateur de précontrainte est mis hors circuit dans la plage comprise entre 10 et 50 ns et, en particulier également mis en circuit.

8. Procédé selon la revendication 7, **caractérisé en ce que** le générateur de précontrainte (5) génère une précontrainte pour un transistor de l'amplificateur de puissance (3) HF.

9. Procédé selon la revendication 8, **caractérisé en ce que** la précontrainte est générée en fonction de la température.
